# EUROPÄISCHE PATENTSCHRIFT

(11) **EP 1 524 742 B1**
(45) Veröffentlichungstag und Bekanntmachung des Hinweises auf die Patenterteilung: **04.04.2007**
(21) Anmeldenummer: 04021505.5
(22) Anmeldetag: 10.09.2004
(51) Int. Cl.: H02B 1/26

(54) **Verteiler zum Anschluss elektrischer Geräte mit Mehrfach-Spannungsversorgung**
Distributor for the connection of electrical devices with multiple voltage supply
Distributeur pour la connexion de dispositifs électriques avec alimentation à tension multiple

(30) Priorität: 15.10.2003 DE 20315837 U
(43) Veröffentlichungstag der Anmeldung: 20.04.2005
(73) Patentinhaber: Weidmüller Interface GmbH & Co. KG, 32760 Detmold (DE)
(72) Erfinder: Reker, Stefan, 33659 Bielefeld (DE)
(74) Vertreter: Specht, Peter

(56) Entgegenhaltungen:
- EP-A- 0 551 649
- EP-A- 1 258 957
- FR-A- 2 615 339
- US-A- 4 780 714
- US-A- 5 716 241

## Beschreibung

Die Erfindung betrifft einen Verteiler der Automatisierungstechnik nach dem Oberbegriff des Anspruch 1.

Verteiler dieser Art insbesondere auch in aktiver Ausführung setzen sich im Bereich der Automatisierungstechnik immer mehr durch und ersetzen dort bisherige, aufwendigere Lösungen.

Eine Schaltung eines Verteilers mit den Merkmalen b) bis f) ist aus der EP 0 551 649 A bekannt.

Optimierungsbedarf besteht dabei insbesondere noch hinsichtlich der Spannungsversorgung der Verteiler und der an sie anzuschließenden elektrischen Geräte.

Die Lösung dieses Problems ist die Aufgabe der Erfindung.

Die Erfindung löst diese Aufgabe durch den Gegenstand des Anspruchs 1.

Danach zeichnet sich die Erfindung durch wenigstens einen weiteren Spannungsversorgungsanschluss zum Anlegen der zwei Versorgungsspannungen aus, wobei die Anschlusspins zum Anschluss der Spannung zur Versorgung der Elektronik der zwei Spannungsversorgungsanschlüsse leitend miteinander verbunden sind und wobei die Anschlusspins der Spannungsversorgungsanschlüsse, die zum Anschluss der Spannung zur Versorgung der an den Verteiler anzuschließenden elektrischen Geräte dienen, über einen Umschalter leitend miteinander verbunden sind.

Durch diese Maßnahme besteht die Möglichkeit dazu, Gruppen von Verteilern separat zu versorgen und vorzugsweise auch zu schalten und/oder - wenn die Gruppenbildung nicht benötigt wird, die Spannung von einem Spannungsversorgungsanschluss zu einem nächsten Verteiler durchzuschleifen, um bei geringem Leistungsbedarf eine Gruppe mehrerer Verteiler nur einmal mit der Spannung zu versorgen.

Es ist ferner zweckmäßig, wenn ein Teil der ersten Anschlüsse leitend mit dem ersten Spannungsversorgungsanschluss und ein weiterer Teil der ersten Anschlüsse leitend mit dem zweiten Spannungsversorgungsanschluss verbunden ist. Auf diese Weise können beispielsweise in einem Notfall auch direkt über entsprechend vorzusehende Ein- /Ausschalter an einer übergeordneten Spannungsversorgung (hier nicht dargestellt) in einfachster Weise auch einzelne Gruppen der angeschlossenen elektrischen Geräte getrennt voneinander von der Spannungsversorgung abgetrennt werden.

Nachfolgend wird die Erfindung unter Bezug auf die Zeichnung anhand von Ausführungsbeispielen näher beschrieben. Es zeigt:
Fig. 1 eine Draufsicht auf eine schematische Darstellung eines Verteilers; und
Fig. 2 eine schematische Ansicht mehrer miteinander verbundener Verteiler.

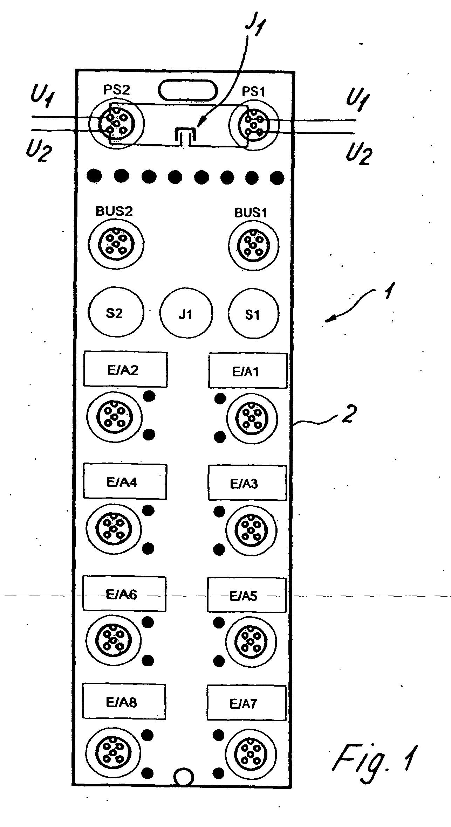

Fig. 1 zeigt einen Verteiler 1 zum Anschluss hier nicht dargestellter elektrischer Geräte wie Aktoren, Sensoren oder dgl., mit einem Gehäuse 2 sowie ersten Anschlüssen E/A1 bis E/A8 zum Anschluss der elektrischen Geräte und zweiten Anschlüssen BUS 1 und BUS2 zum Anschluss eines übergeordneten Bussystems sowie hier zwei weiteren Anschlüssen PS1 und PS2 zum Anschluss von Versorgungsleitungen.

Darüber hinaus weist das Gehäuse 1 auf seiner mit den Anschlüssen versehenen Oberseite mehrere-hier beispielhaft zwei-Adressierschalter S1 und S2 sowie einen Umschalter J1 auf.

Mit den Adressierschaltem S1 und S2 können den ersten Anschlüssen E/A1, ... Adressen zugewiesen werden, wohingegen der Umschalter (Jumper J1) z.B. zum Verbinden und Trennen der Versorgungsleitungsanschlüsse PS1 und PS2 (z.B. im "M8-Standard" oder dgl.) dient.

Die Adressier- und die Umschalter S1, S2, J1 sind hier in einem Feld F aus einem transparentem Material angeordnet, welches beispielsweise mittels Leuchtdioden oder dgl. direkt oder über zwischengeschaltete Lichtleiter beleuchtet wird, um das Auffinden, das Überprüfen der Einstellung und die Handhabung der Schalter S1, S2 und J1 zu erleichtern.

Die Spannungsversorgungsanschlüsse PS1 und PS2 weisen jeweils mehrere Anschlusspins auf, welche zum Teil zur Signalübertragung und zum Teil zur Spannungsversorgung dienen.

Jedem der Verteiler nach Art der Fig. 1 wird an jedem der beiden Spannungsversorgungsanschlüsse PS1 und PS2 jeweils an einem der Pins eine erste Versorgungsspannung U1 zur Versorgung der Elektronik des Verteilers an sich und eine zweite Versorgungsspannung U2 bzw. U2' (z.B. je 24V von zwei getrennten Spannungsversorgungseinheiten) zur Versorgung der an die Anschlüsse E/A1, ... des Verteilers anzuschließenden elektrischen Geräte zugeführt.

Nach Fig. 1 sind - schematisch angedeutet - die beiden Anschlusspins zum Anschluss der Spannungen "U1" der Spannungsversorgungsanschlüsse PS1 und PS2 leitend miteinander verbunden, wohingegen in die Verbindung der beiden Anschlusspins zum Anschluss der Spannungen "U2" und "U2 "' der Spannungsversorgungsanschlüsse PS 1 und PS2 ein Umschalter - Jumper - J1 geschaltet ist, mit dem es möglich ist, diese beiden Anschlusspins entweder leitend miteinander zu verbinden oder voneinander zu trennen.

Mit dem Jumper J1 können auf diese Weise die entsprechenden Anschlusspins für die Spannungen U2, U2' zur Versorgung der an die Verteiler angeschlossenen elektrischen Geräte) entweder miteinander verbunden oder voneinander getrennt werden. Das Trennen ist hilfreich, um eine getrennte Versorgung von Gruppen der ersten Anschlüsse E/A1, ... vorzunehmen.

Beispielsweise können bei entsprechender Verschaltung eine erste Gruppe E/A1 bis E/A4 und eine zweite Gruppe E/A5 bis E/A8 gebildet werden, wenn intern die Anschlüsse E/A1 bis E/A4 mit dem ersten Spannungsversorgungsanschluss PS1 und die Anschlüsse E/A5 bis E/A8 mit dem weiteren Spannungsversorgungsanschluss PS2 verbunden sind.

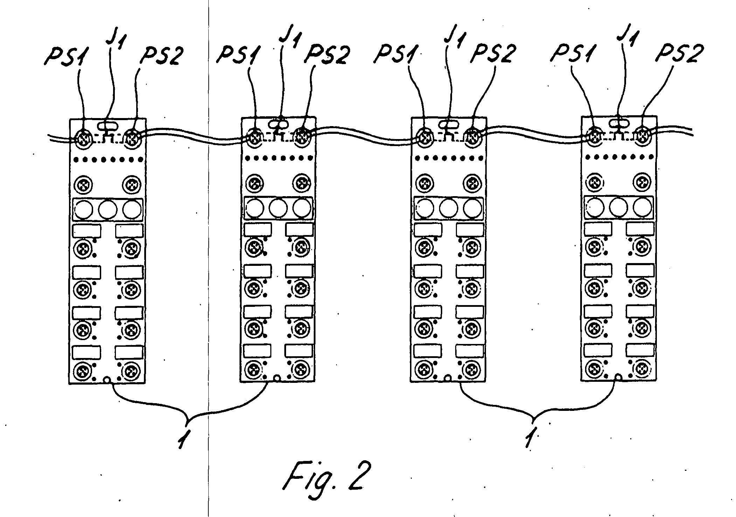

Darüber hinaus besteht die Möglichkeit dazu, jedem Verteiler eine höhere Leistung zuzuführen und/oder - wenn die Gruppenbildung nicht benötigt wird, die Spannung von einen Spannungsversorgungsanschluss bei aufgestecktem Jumper J1 zu einem nächsten Verteiler durchzuschleifen, um bei geringem Leistungsbedarf eine Gruppe mehrerer Verteiler nur einmal mit der Spannung zu versorgen (Fig. 2).

So ist möglich, die Spannungsversorgung in Fällen, in denen nur geringere Leistungen benötigt werden, bei gesetztem Jumper J1 (der in diesem Fälle die beiden Anschlusspins zum Anschluss der Spannungen U2 miteinander verbindet), nur an den einen An schluss PS1 oder PS2 eines ersten Verteilers zu legen und die Spannungsversorgung ansonsten von Verteiler zu Verteiler durchzuschleifen. (Fig. 2).

## Patentansprüche

1. Verteiler zum Anschluss elektrischer Geräte wie Aktoren, Sensoren oder dgl., mit
a) ersten Anschlüssen (E/A1 - E/A2) zum Anschluss der elektrischen Geräte,
b) wenigstens einem zweiten Anschluss (BUS1, BUS2) zum Anschluss eines übergeordneten Bussystems, und
c) einem Spannungsversorgungsanschluss (PS1) mit mehreren Anschlusspins zum Anlegen von wenigstens zwei Versorgungsspannungen (U1, U2), von denen die eine zur Versorgung einer internen Elektronik und die andere zur Versorgung der an die Verteiler anzuschließenden elektrischen Geräte dient,
d) mit wenigstens einem weiteren Spannungsversorgungsanschluss (PS2) zum Anlegen der zwei Versorgungsspannungen (U1, U2),
e) wobei die Anschlusspins zum Anschluss der Spannung (U1) zur Versorgung der Elektronik der zwei Spannungsversorgungsanschlüsse leitend miteinander verbunden sind, **gekennzeichnet durch**
f) ein Gehäuse,
g) wobei des Verteiler ein Verteiler der Automatisierungstechnik ist, und
h) wobei die Anschlusspins der Spannungsversorgungsanschlüsse (PS1, PS2), die zum Anschluss der Spannung zur Versorgung der an den Verteiler anzuschließenden elektrischen Geräte dienen, über einen Umschalter (J1) leitend miteinander verbunden sind.

2. Verteiler nach Anspruch 1, **dadurch gekennzeichnet, dass** ein Teil der ersten Anschlüsse (E/A1- E/A4) leitend mit dem ersten Spannungsversorgungsanschluss (PS 1) und ein weiterer Teil der ersten Anschlüsse (E/A5 bis E/A8) leitend mit dem zweiten Spannungsversorgungsanschluss (PS2) verbunden ist.

## Claims

1. Distributor for the connection of electrical devices such as actuators, sensors or similar, with
a) first connections (E/A1 - E/A2) for the connection of the electrical devices,
b) at least one second connection (BUS1, BUS2) for the connection of a superordinate bus system, and
c) a voltage supply connection (PS1) with a plurality of connection pins for feeding at least two supply voltages (U1, U2), of which one serves to supply an internal electronic unit and the other to supply the electrical devices to be connected to the distributors,
d) with at least one further voltage supply connection (PS2) for feeding the two supply voltages (U1, U2),
e) wherein the connection pins for the connection of the voltage (U1) for the supply of the electronic unit of the two voltage supply connections are conductively connected to each other, **characterised by**
f) a housing,
g) wherein the distributor is a distributor of automation technology, and
h) wherein the connection pins of the voltage supply connections (PS1, PS2) which serve for the connection of the voltage for the supply of the electrical devices to be connected to the distributor are conductively connected to each other by means of a change-over switch (J1).

2. Distributor according to claim 1, **characterised in that** a proportion of the first connections (E/A1 - E/A4) are conductively connected to the first voltage supply connection (PS1) and a further proportion of the first connections (E/A5 to E/A8) are conductively connected to the second supply voltage connection (PS2).

## Revendications

1. Tableau de distribution destiné au branchement d'appareils électriques, tels que des actionneurs, des détecteurs ou similaires, comprenant
a) des premiers branchements (E/A1 - E/A2) permettant le branchement des appareils électriques,
b) au moins un deuxième branchement (BUS1, BUS2) permettant le branchement d'un système de bus principal, et
c) un branchement d'alimentation en tension (PS1) comportant plusieurs broches de raccordement permettant d'appliquer au moins deux tensions d'alimentation (U1, U2), dont une sert à l'alimentation d'un dispositif électronique interne et l'autre à l'alimentation des appareils électriques qu'il convient de brancher sur le tableau de distribution,
d) au moins un deuxième branchement d'alimentation en tension (PS2) supplémentaire permettant d'appliquer les deux tensions d'alimentation (U1, U2),
e) les broches de raccordement pour le raccordement de la tension (U1) afin d'alimenter le dispositif électronique des deux branchements d'alimentation en tension étant reliées les unes aux autres de façon conductrice,
**caractérisé par**
f) un boîtier
g) le panneau de distribution étant un panneau de distribution destiné à la technique d'automatisation, et
h) les broches de raccordement des branchements d'alimentation en tension (PS1, PS2) servant au raccordement de la tension afin d'alimenter les appareils électriques destinés à être branchés sur le tableau de distribution étant reliées les unes aux autres de façon conductrice, par l'intermédiaire d'un commutateur (J1).

2. Tableau de distribution selon la revendication 1, **caractérisé en ce qu'**une partie des premiers banchements (E/A1 - E/A4) sont reliés de façon conductrice au premier branchement d'alimentation en tension (PS1) et **en ce qu'**une autre partie des premiers branchements (E/A5 à E/A8) sont reliés de façon conductrice au deuxième branchement d'alimentation en tension (PS2).
